# EUROPÄISCHE PATENTANMELDUNG

(11) **EP 2 564 941 A1**
(43) Veröffentlichungstag der Anmeldung: **06.03.2013**
(21) Anmeldenummer: 11179586.0
(22) Anmeldetag: 31.08.2011
(51) Int. Cl.: B05C 17/005

(54) **Applikatorkopf, handgehaltenes Applikationsgerät, Applikationsvorrichtung und Verfahren zur Herstellung eines Solarthermie- oder Photovoltaikmoduls**

(71) Anmelder: Sika Technology AG, 6340 Baar (CH)
(72) Erfinder: Buck, Manuel, 5412 Gebenstorf (CH)
(74) Vertreter: Sika Patent Attorneys

(57) **Zusammenfassung**

Applikatorkopf zum Aufsetzen auf eine mit einer Austragnadel versehende Pastenaustragvorrichtung, zum Applizieren eines pastösen Kleb- oder Dichtstoffes in eine langgestreckte Vertiefung, wobei der Applikatorkopf eine ebene, feste Gleitfläche mit einer die Breite der zu füllenden Vertiefung übersteigenden Breite hat, in der eine an die Austragnadel angepasste Austragöffnung vorgesehen ist und die mit einem Filz-, Schaum- oder Textilmaterial belegt ist.

## Beschreibung

### Technisches Gebiet

Die Erfindung betrifft einen Applikatorkopf zum Aufsetzen auf eine mit einer Austragnadel versehene Pastenaustragvorrichtung. Sie betrifft des Weiteren ein mit einem solchen Applikatorkopf ausgestattetes handgehaltenes Applikationsgerät oder eine koordinatengesteuerte Applikationsvorrichtung sowie schließlich ein Verfahren zur Herstellung eines Solarthermie- oder Photovoltaikmoduls oder einer Fassaden-, Decken-, Wintergarten-, Gewächshaus- oder Innenwandverglasung.

### Stand der Technik

Bei der Herstellung von Solarthermiemodulen (Sonnenkollektoren) oder Photovoltaikmodulen sowie auch bei der Herstellung von Wandverglasungen für verschiedene Einsatzzwecke sind großflächige (Glas-)Tafeln in Gehäusewannen, Rahmen oder sonstige Tragkonstruktionen klebend einzufügen, oder es ist ein Randbereich der jeweiligen Tafel gegenüber der Tragkonstruktion abzudichten. Hierzu ist ein im Ausgangszustand pastöser Kleb- oder Dichtstoff mittels einer handgehaltenen oder koordinatengesteuert betriebenen Pastenaustragvorrichtung unter kontinuierlichem Austragen des jeweiligen Kleb- oder Dichtstoffes so längs der Kante der Tafel zu führen, dass eine dort verlaufende Vertiefung (Nut bzw. Rinne), die vielfach eine Hinterschneidung aufweist, zuverlässig und sauber gefüllt wird. Dies stellt hohe Anforderungen an das handwerkliche Können des Bedieners der Pastenaustragvorrichtung und wirft insbesondere in Eckbereichen Probleme auf, die vielfach zu ästhetischen und u. U. auch qualitativen Mängeln der Verklebung bzw. Abdichtung führen.

Der Erfindung liegt die Aufgabe zugrunde, eine Lösung für dieses Problem anzugeben, die eine leichte Handhabung der Pastenaustragvorrichtung zur Erzeugung einer qualitativ und ästhetisch hochwertigen Verklebung bzw. Abdichtung auch ohne besondere Qualifikation und Erfahrung sowie ohne aufwändige Nacharbeiten ermöglicht.

### Offenbarung der Erfindung

Mit der Erfindung wird ein Applikatorkopf mit den Merkmalen des Anspruchs 1 bereitgestellt. Zweckmäßige Fortbildungen des Erfindungsgedankens sind Gegenstand der abhängigen Ansprüche. Des Weiteren werden ein handgehaltenes Applikationsgerät mit den Merkmalen des Anspruchs 11, eine Applikationsvorrichtung mit den Merkmalen des Anspruchs 12 sowie Verfahren mit den Merkmalen des Anspruchs 14 und 15 bereitgestellt.

Die Erfindung geht von der Überlegung aus, die Handhabungs-Nachteile von Pastenaustragvorrichtungen mit Standard-Austragnadeln bzw. -düsen durch die Bereitstellung eines auf dieses aufzusetzenden Zusatzteils zu beheben, welches nachfolgend als Applikatorkopf bezeichnet wird. Im Bereich der Erfindung liegt aber auch eine Realisierung, bei der die herkömmliche Austragnadel gegen einen im Übrigen an die Pastenaustragvorrichtung passenden Applikatorkopf ausgetauscht wird. Weiterhin schließt die Erfindung den Gedanken ein, den besagten Applikatorkopf mit Mitteln zum Glätten der Oberfläche einer frisch ausgetragenen Kleb- oder Dichtstoffraupe zu versehen. Schließlich gehört zur Erfindung der Gedanke, hierzu eine Gleitfläche vorzusehen, die mit einem speziellen Material belegt ist, welches einerseits gleitfähig sowohl auf den Umgebungsflächen als auch auf der frischen Kleb- oder Dichtstoffschicht ist und andererseits ein Verschmieren von Klebstoff auf die umgebenden Flächen verhindert.

In einer Ausführung der Erfindung hat der Applikatorkopf Befestigungsmittel zur, insbesondere abnehmbaren, Anbringung an der Pastenaustragvorrichtung. In einer Ausgestaltung weisen die Befestigungsmittel eine Spreizkonuseinrichtung auf. In einer weiteren Ausgestaltung ist vorgesehen, dass die Befestigungsmittel einen Rastmechanismus oder Schraubverbindungsmittel aufweisen. Sonstige Ausgestaltungen der Befestigungsmittel ergeben sich aus der speziellen Konstruktion der Pastenaustragvorrichtung, speziell im Hinblick auf eine einfache und sichere Anbringung des Applikatorkopfes an dieser.

In einer weiteren Ausführung der Erfindung ist vorgesehen, dass die Befestigungsmittel eine vorbestimmte, insbesondere elastische, Deformierbarkeit zum Ausgleich von Positions- und/oder Winkeländerungen der Austragnadel relativ zu der zu füllenden Vertiefung aufweisen. Hierdurch lässt sich eine sichere Führung des Applikatorkopfes über die freie Oberfläche der jeweiligen Vertiefung, unter Abstützung auf Umgebungsflächen, auch bei manueller Handhabung erreichen.

Eine weitere Ausführung zeichnet sich dadurch aus, dass die Gleitfläche rechteckig ist und eine wesentlich, insbesondere um mehr als das Zweifache, größere Länge als Breite hat. Die Gleitfläche kann aber auch eine von der Rechteckform abweichende Gestalt haben, solange allseitig der Abstand der Austragöffnung vom Rand der Gleitfläche hinreichend groß ist. Bei einem Applikatorkopf zum Einsatz in einer koordinatengesteuerten Klebe- oder Abdichtungsanlage kann auch eine kreisförmige oder elliptische Gleitfläche durchaus sinnvoll sein.

In einer weiteren Ausführung ist die Gleitfläche abgewinkelt oder abgestuft ausgebildet. Diese Ausführung eignet sich besonders für Montage-Konfigurationen, bei denen zu beiden Seiten der zu füllenden Vertiefung Umgebungsflächen auf unterschiedlichem Höhenniveau vorhanden sind, bei denen die erzeugte Kleb- oder Dichtstoffraupe also an eine über ihre Oberfläche aufragende Wand angrenzt.

In einer weiteren Ausführung ist der Applikatorkopf ausgeführt als Wegwerfartikel mit einem fest auf die Gleitfläche aufgebrachten Streifen oder Formkörper, dessen Wirkfläche durch das Filz-, Schaum- oder Textilmaterial gebildet ist.

In einer alternativen Ausführung des Applikatorkopfes ist die Gleitfläche lose mit einem quasi-endlosen, in vorbestimmten Abständen jeweils mit einer Austragöffnung versehenen Streifen des Filz-, Schaum- oder Textilmaterials belegt. Der Kopf hat dann eine Spender- und Aufnehmereinrichtung mit einem Spenderabschnitt zum Spenden neuer Streifenabschnitte, einem Aufnehmerabschnitt zur Aufnahme verbrauchter Streifenabschnitte und Fördermitteln zum schrittweisen Fördern des Streifens zwischen dem Spender- und Aufnehmerabschnitt jeweils um den vorbestimmten Abstand vorgesehen ist. Zur Erfindung gehört in diesem Kontext auch ein speziell gestalteter Streifen des Filz-, Schaum- oder Textilmaterials als Verbrauchsmaterial.

In einer Ausgestaltung dieser Ausführung ist die Spender- und Aufnehmereinrichtung als Streifen-Kassette mit manuell oder über die Pastenaustragvorrichtung betätigten Fördermitteln ausgeführt. In diesem Zusammenhang gehört zur Erfindung die erwähnte Streifen-Kassette als Verbrauchsmaterial.

Wo in dieser Patentanmeldung von einem Filz-, Schaum- oder Textilmaterial oder einem Streifen oder Formkörper aus oder mit einem solchen Material die Rede ist, sollen Kunststoff-Filze oder Kunststoff-Schäume ebenso einbegriffen sein wie Naturfaser-Filze oder Naturschwämme, und Kunstfaser-Textilmaterialien ebenso wie Naturfaser-Textilmaterialien, sowie auch Schaum/Textil- oder Schaum/Filz-Kombinationen in verschiedenartiger Konfiguration. Wesentlich ist, dass das Material, mit dem die Gleitfläche belegt (oder aus dem sie gebildet) ist, hohe Gleitfähigkeit sowohl auf den Umgebungsflächen als auch auf der Oberfläche der frisch ausgetragenen Klebstoff- oder Dichtstoffschicht hat.

Während ein handgehaltenes Applikationsgerät, welches mit einem erfindungsgemäßen Applikatorkopf versehen ist, zur Glättung der Kleb- oder Dichtstoffschicht in Eckbereichen der zu füllenden Vertiefung und zur Vermeidung von Unsauberkeiten in diesem Bereich vom Bediener händisch etwas vor und zurück bewegt und ggfs. gedreht werden sollte, werden bei einer koordinatengesteuerten Applikationsvorrichtung entsprechende Bewegungen durch die Steuereinrichtung angesteuert. Hierbei hängt der konkrete Bewegungsablauf von der geometrischen Konfiguration der Fuge und der Umgebungsflächen sowie auch von der speziell gewählten Gleitflächengeometrie des Applikatorkopfes ab. Es kann eine reine Drehbewegung oder eine reine Vor/Zurück-Bewegung ausreichend sein; ggfs. lässt sich mit einer Kombination aus beiden Bewegungen aber ein noch besseres Ergebnis erzielen.

Am Ende einer Austrag-Strecke wird der Filz bevorzugt über eine Reinigungsfläche geführt, welche Vorzugsweise aus einem Reinigungspapier oder Stoff besteht, um ein Verschmutzen der Begrenzungsflächen nächsten zu befüllenden Vertiefung zu vermeiden und gleichzeitig eine etwaige Verschmutzung zu korrigieren. Die Reinigungsfläche sollte sich auf der gleichen Höhe wie die Oberfläche der zu verfüllenden Vertiefung befinden, um so das Ende einfach überfahren zu können.

### Beschreibung der Zeichnungen

Vorteile und Zweckmäßigkeiten der Erfindung werden aus der nachfolgenden Beschreibung bevorzugter Ausführungsbeispiele anhand der Figuren deutlich. Von diesen zeigen:
- Fig. 1: eine schematische Querschnittsdarstellung eines Applikatorkopfes gemäß einer Ausführung der Erfindung,
- Fig. 2: eine Seitenansicht eines Applikatorkopfes gemäß einer weiteren Ausführung der Erfindung,
- Fig. 3A und 3B: schematische Querschnittsdarstellungen weiterer Ausführungsformen des erfindungsgemäßen Applikatorkopfes und
- Fig. 4: eine skizzenartige Darstellung der Nutzung einer erfindungsgemäßen Applikationsvorrichtung zur Durchführung eines erfindungsgemäßen Verfahrens.

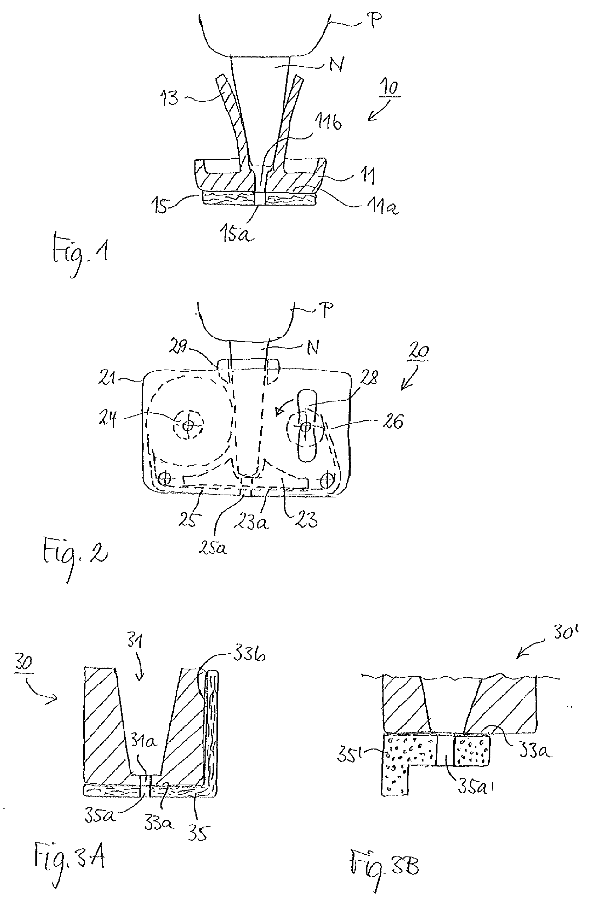

Fig. 1 zeigt skizzenartig einen Applikatorkopf 10, aufgesetzt auf eine Austragnadel N einer Pastenaustragvorrichtung P, wie sie zum Austragen von Kleb- oder Dichtstoffen üblicherweise verwendet wird. Der Applikatorkopf 10 ist annähernd stempelförmig, mit einem Bodenabschnitt 11 und einem von diesem aufstehenden Spreizkonusabschnitt 13. In letzteren wird die Austragnadel N soweit hineingedrückt, dass die elastische Rückstellkraft der aus Kunststoff geformten, durch Schlitze voneinander separierten Konusabschnitte den Applikatorkopf reibschlüssig auf der Austragnadel N hält. Die freie Oberfläche 11a des Bodenabschnitts 11 bildet eine ebene Gleitfläche und ist mit einem aufgeklebten Filz 15 belegt. Der Bodenabschnitt 11 und der Filz 15 haben jeweils eine zentrale Öffnung 11b bzw. 15a, die im Wesentlichen mit der Längsachse der Austragnadel N der Pastenaustragvorrichtung P im aufgesetzten Zustand des Applikators fluchtet.

Über die Austragnadel ausgetragener Kleb- oder Dichtstoff gelangt durch die Öffnungen 11b und 15a unter die freie Oberfläche des Filzes, also beispielsweise in eine dort vorhandene und mit Kleb- oder Dichtstoff zu füllende Vertiefung. Eine langgestreckte Vertiefung wird mittels der Pastenaustragvorrichtung P mit aufgesetztem Applikatorkopf 10 gefüllt, indem ihr Längsverlauf unter kontinuierlichem Austrag von Kleb- oder Dichtstoff abgefahren und dabei zugleich mittels des Filzes 15 die Oberfläche des ausgetragenen Kleb- oder Dichtstoffs mit den Umgebungsflächen plan gemacht und in hoher Qualität geglättet wird.

Fig. 2 zeigt als weitere Ausführungsform einen Applikatorkopf 20 in Kassettenform. In einem Kassettengehäuse 21 ist durch einen eingesetzten Formkörper 23 durch eine Gleitfläche 23a definiert. Der Formkörper 23 ist zugleich derart geformt, dass in ihn die Spitze der Austragnadel N einer Pastenaustragvorrichtung P eingreifen und dort festgehalten werden kann. Das Kassettengehäuse 21 umfasst weiterhin einen ersten und zweiten Spulenwickel 24, 26 als Spenderabschnitt bzw. Aufnehmerabschnitt eines quasi-endlosen Filzstreifens 25, der in vorbestimmten Abständen mit Löchern 25a zum Durchtritt von Kleb- bzw. Dichtstoffen versehen ist.

Mittels eines manuell zu betätigenden Knebels 28 am zweiten Bandwickel (Aufnehmerabschnitt) 26 kann der Filzstreifen 25 jeweils um den vorbestimmten Abstand gefördert werden, um verschmutzte und hierdurch verbrauchte Abschnitte durch frisches Filzmaterial zu ersetzen und um eine Trennung zum Klebstoff zu erzeugen, welche ein verschmutzungsfreies und fadenloses Absetzen des Applikator ermöglicht. Ein Befestigungsabschnitt 29 an der Oberseite der Kassette 20, der etwa mit einem Gewindeabschnitt oder Klebstoff versehen sein kann, dient zur sicheren Befestigung der Kassette an der Pastenaustragvorrichtung P.

Die Ausführung nach Fig. 2 eignet sich besonders zum Einsatz mit pumpenbetriebenen und koordinatengesteuerten Applikationsvorichtungen für industrielle Anwendungen; dann wird aber die handbetriebene Fördereinrichtung (Knebel 28) vorzugsweise durch einen elektrischen und elektronisch gesteuerten Antrieb ersetzt sein.

Fig. 3A und 3B zeigen als spezielle Konfigurationen Applikatorköpfe, die vorteilhaft bei nicht in einer gemeinsamen Fläche liegenden Dichtstoff- und Umgebungsoberflächen einsetzbar sind. Fig. 3A zeigt einen Applikatorkopf 30 mit einer zentralen konischen Ausnehmung 31 zum Einsetzen einer (nicht dargestellten) Austragnadel, der in seiner Grundform quaderförmig ist und zwei zueinander senkrecht stehende Gleitflächen 33a, 33b aufweist, die beide mit einem entsprechend über Eck verlegten Filzstreifen 35 bedeckt sind. Wiederum ist sowohl im Grundkörper des Applikators 30 eine Bohrung 31a als auch im Filz 35 eine in ihrer Positionierung hierzu korrespondierende Öffnung 35a vorgesehen. Mit diesem Applikatorkopf lassen sich leicht und sauber langgestreckte Vertiefungen mit Kleb- oder Dichtstoff füllen, die einseitig von einer aufstehenden Wand begrenzt sind.

Der in Fig. 3B skizzenartig gezeigte Applikator 30' ist in seiner Grundform ähnlich dem Applikator 30 nach Fig. 3A, trägt jedoch an seiner Gleitfläche 33a einen Schaumstoff-Formkörper 35', der im Querschnitt L-förmig ist. Eine Öffnung 35a' sichert auch hier den Durchtritt von aus einer Pastenaustragvorrichtung ausgetragenem Kleb- oder Dichtstoff bis auf die freie Oberfläche des Formkörpers und somit in eine hierunter befindliche und mit dem Kleb- oder Dichtstoff zu füllende Vertiefung. Der nach unten überstehende Teil des Formkörpers 35' dient zum sauberen Abstreifen von ausgetretenem Material von einer nahe der zu füllenden Vertiefung abfallenden Wand.

Neben den in Fig. 3A und 3B lediglich beispielhaft dargestellten "dreidimensionalen" Konfigurationen sind viele andere möglich, um speziellen Fugen- und Wandungskonfigurationen von Sonnenkollektoren, Solarmodulen, Verglasungen etc. gerecht zu werden.

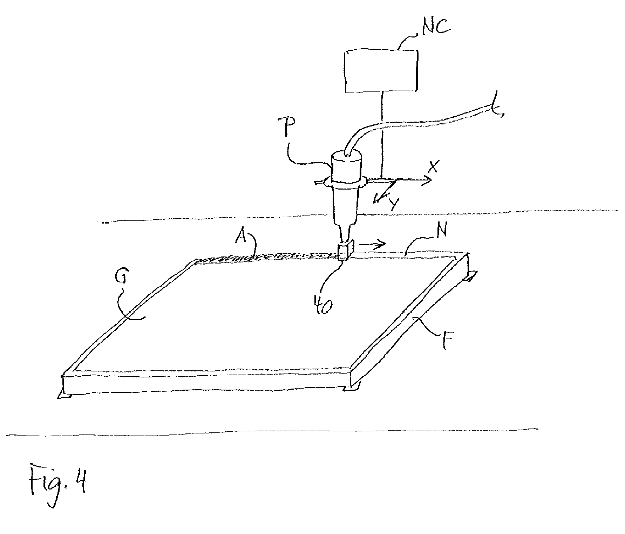

Fig. 4 zeigt skizzenartig den Einsatz einer mit einem erfindungsgemäßen Applikatorkopf 40 bestückten, pumpenbetriebenen und koordinatengesteuerten Applikationsvorrichtung P für den industriellen Einsatz zur Herstellung einer Fugenverklebung A in einer umlaufenden Nut N, die zwischen einem Tragrahmen F eines Solarkollektors und einer hierin einzusetzenden Glasplatte G vorhanden ist. Eine Koordinatensteuereinheit NC der Applikationsvorrichtung ist so programmiert, dass sie die Applikationsvorrichtung mit einer zum vollständigen Füllen der Nut N geeigneten Geschwindigkeit längs der Nut führt und in den Eckbereichen jeweils kurze Vor/Rück-Bewegungen ausführt, um auch dort eine saubere Glättung der ausgetragenen Klebstoffschicht A mittels des Applikatorkopfes 40 gemäß dem oben erläuterten Wirkprinzip zu bewirken.

Die Ausführung der Erfindung ist nicht auf diese Beispiele beschränkt, sondern ebenso in einer Vielzahl von Abwandlungen möglich, die im Rahmen fachgemäßen Handelns liegen.

## Patentansprüche

1. Applikatorkopf zum Aufsetzen auf eine mit einer Austragnadel versehende Pastenaustragvorrichtung, zum Applizieren eines pastösen Kleb- oder Dichtstoffes in eine langgestreckte Vertiefung, wobei der Applikatorkopf eine ebene, feste Gleitfläche mit einer die Breite der zu füllenden Vertiefung übersteigenden Breite hat, in der eine an die Austragnadel angepasste Austragöffnung vorgesehen ist und die mit einem Filz-, Schaum- oder Textilmaterial belegt ist.

2. Applikatorkopf nach Anspruch 1, mit Befestigungsmitteln zur, insbesondere abnehmbaren, Anbringung an der Pastenaustragvorrichtung.

3. Applikatorkopf nach Anspruch 2, wobei die Befestigungsmittel eine Spreizkonuseinrichtung aufweisen.

4. Applikatorkopf nach Anspruch 2, wobei die Befestigungsmittel einen Rastmechanismus oder Schraubverbindungsmittel aufweisen.

5. Applikatorkopf nach einem der Ansprüche 2 - 4, wobei die Befestigungsmittel eine vorbestimmte, insbesondere elastische, Deformierbarkeit zum Ausgleich von Positions- und/oder Winkeländerungen der Austragnadel relativ zu der zu füllenden Vertiefung aufweisen.

6. Applikatorkopf nach einem der vorangehenden Ansprüche, wobei die Gleitfläche rechteckig ist und eine wesentlich, insbesondere um mehr als das Zweifache, größere Länge als Breite hat.

7. Applikatorkopf nach einem der vorangehenden Ansprüche, wobei die Gleitfläche, abgewinkelt oder abgestuft ausgebildet ist.

8. Applikatorkopf nach einem der vorangehenden Ansprüche, ausgeführt als Wegwerfartikel mit einem fest auf die Gleitfläche aufgebrachten Streifen oder Formkörper, dessen Wirkfläche durch das Filz-, Schaum- oder Textilmaterial gebildet ist.

9. Applikatorkopf nach einem der Ansprüche 1 - 6, wobei die Gleitfläche lose mit einem quasi-endlosen, in vorbestimmten Abständen jeweils mit einer Austragöffnung versehenen Streifen des Filz-, Schaum- oder Textilmaterials belegt ist und eine Spender- und Aufnehmereinrichtung mit einem Spenderabschnitt zum Spenden neuer Streifenabschnitte, einem Aufnehmerabschnitt zur Aufnahme verbrauchter Streifenabschnitte und Fördermitteln zum schrittweisen Fördern des Streifens zwischen dem Spender- und Aufnehmerabschnitt jeweils um den vorbestimmten Abstand vorgesehen ist.

10. Applikatorkopf nach Anspruch 9, wobei die Spender- und Aufnehmereinrichtung als Streifen-Kassette mit manuell oder über die Pastenaustragvorrichtung betätigten Fördermitteln ausgeführt ist.

11. Handgehaltenes Applikationsgerät mit einer motor- oder druckluftbetriebenen Pastenaustragvorrichtung und einem Applikatorkopf nach einem der vorangehenden Ansprüche.

12. Applikationsvorrichtung mit einer koordinatengesteuert geführten pumpen- oder druckluftbetriebenen Pastenaustragvorrichtung und einem Applikatorkopf nach einem der Ansprüche 1 - 10.

13. Applikationsvorrichtung nach Anspruch 12, mit einer Koordinatensteuerung, die zur Ausführung einer vorbestimmten Vor-Rück-Bewegung und/oder Drehbewegung der mit dem Applikatorkopf bestückten Austragnadel in Eckbereichen der zu füllenden Vertiefung ausgebildet ist.

14. Verfahren zur Herstellung eines Solarthermie- oder Photovoltaikmoduls aus einer Gehäusewanne oder einem Gehäuserahmen und einer in diese/n einzusetzenden Glas- oder Solarzellenplatte, wobei eine langgestreckte Vertiefung am Rand der Glas- oder Solarzellenplatte mittels eines Applikationsgerätes nach Anspruch 11 oder einer Applikationsvorrichtung nach Anspruch 12 oder 13 mit Kleb- oder Dichtstoff gefüllt wird.

15. Verfahren zur Herstellung einer Fassaden-, Decken-, Wintergarten-Gewächshaus- oder Innenwandverglasung mit einem Tragrahmen und mindestens einer in diese einzusetzenden Glasplatte, wobei eine langgestreckte Vertiefung am Rand der Glasplatte mittels eines Applikationsgerätes nach Anspruch 11 oder einer Applikationsvorrichtung nach Anspruch 12 oder 13 mit Kleb- oder Dichtstoff gefüllt wird.
